# EUROPEAN PATENT APPLICATION

(11) **EP 3 076 452 A1**
(43) Date of publication of application: **05.10.2016**
(21) Application number: 14865167.2
(22) Date of filing: 19.11.2014
(51) Int. Cl.: H01L 51/52, H01L 51/56

(54) **METHOD FOR MANUFACTURING SUBSTRATE, SUBSTRATE, METHOD FOR MANUFACTURING ORGANIC ELECTROLUMINESCENCE DEVICE, AND ORGANIC ELECTROLUMINESCENCE DEVICE**

(30) Priority: 27.11.2013 KR 20130145508; 27.01.2014 KR 20140009860
(71) Applicant: Neoviewkolon Co., Ltd., Chungcheongnam-do 350-883 (KR)
(72) Inventor: YOO, Min-Sang, Asan-si Chungcheongnam-do 336-765 (KR); IM, Woo-Bin, Hongseong-gun Chungcheongnam-do 350-801 (KR); KIM, Tae-Su, Hongseong-gun Chungcheongnam-do 350-801 (KR)
(74) Representative: Ter Meer Steinmeister & Partner
(86) International application number: PCT/KR2014/011104
(87) International publication number: WO 2015/080422

(57) **Abstract**

The purpose of the present invention is to reduce light, which is absorbed at an interface of an organic electroluminescence device and disappears, thereby improving the efficiency of extraction of light that is drawn to the outside. A substrate 11 is coated with polymer to form a polymer layer 12; ion bombardment stress resulting from plasma is applied to the polymer layer 12 to form a corrugated layer 13 having a plurality of corrugated parts; and a first electrode, an organic light-emitting layer, and a second electrode are successively formed on the substrate, on which the corrugated layer is formed, thereby manufacturing an organic electroluminescence device. In addition, a metal layer 23 may be additionally formed on the polymer layer, ion bombardment stress and thermal stress may be applied simultaneously to form corrugated parts, and the metal layer may then be removed.

## Description

### [Technical Field]

The present invention relates to a method for manufacturing a substrate, a method for manufacturing an organic electroluminescence device using the substrate, and a substrate and an organic electroluminescence device manufactured by the methods.

### [Background Art]

An organic electroluminescence device (hereinafter, briefly referred to as an organic EL device) is a light emitting device having a structure in which an organic light-emitting layer including an organic compound is inserted between a pair of electrodes which includes a cathode and an anode and is formed on a transparent substrate such as a glass substrate, etc., and holes and electrons are injected into the organic light-emitting layer from the pair of electrodes to recombine the holes and the electrons, thereby generating excitons, such that emission of light when activity of the excitons is lost is used to display, and the like.

An organic electroluminescence display device using the organic EL device as a light emitting device is in the spotlight as a flat panel display device due to having excellent luminance and viewing angle characteristics with light weight and thin thickness, as compared to other display devices, in addition, use of the organic EL device also has been drawn as a light source for lighting, etc.

When the organic EL device is used as a display device, a light source for lighting, or the like, in terms of utilization efficiency and reduction of power consumption, it is preferable to emit the light generated from the organic light-emitting layer in the organic EL device, to an outside of the device as much as possible. However, it is known that as a practical matter, only 20% of the light generated from the organic light-emitting layer is emitted due to various causes. The causes thereof include absorption and extinction of light in an organic material itself, absorption and extinction of light at an interface between the organic light-emitting layer made of organic materials and the electrodes made of metals, etc., extinction of light in the device without being emitted to the outside due to so called plasmonic resonance, or the like. Further, it is also known that total reflection due to a difference in a refractive index between the electrode and the substrate deteriorates light extraction efficiency.

Therefore, it is one of the important tasks in the field of organic EL device that the light is emitted to the outside of the device as much as possible by improving the low light extraction efficiency as described above.

As a technique for improving light extraction efficiency known in the related art, there are techniques suggested in Patent Documents 1 and 2. The documents disclose the techniques in which a scattering layer is formed on an outer surface of the substrate or the organic light-emitting layer, so as to improve the light extraction efficiency by using the scattering layer for scattering action of the light generated from the organic light-emitting layer.

However, in Patent Documents 1 and 2, the scattering layer is formed by a method of dispersing scattering particles in a solvent, and inserting the same between a transparent electrode and a substrate to be coated therewith, such that it is difficult to achieve mass production because complete dispersion of the particles is impossible.

As another technique known in the related art, there is a technique described in Patent Document 3. FIG. 1 is a schematic cross-sectional view of an organic EL device of Patent Document 3.

As illustrated in FIG. 1, the organic EL device of Patent Document 3 has a structure in which a polymer 70, a first electrode 61 made of ITO, etc., an organic light-emitting layer 62, and a second electrode 63 made of metal are sequentially disposed on a substrate 50, and the polymer 70 has a corrugated part 71 formed thereon in a shape such as a circular, an elliptical, a hemispherical shape, or the like.

According to a method for forming the corrugated part 71, the corrugated part 71 is formed by forming a hydroxyl group on the substrate 50 by oxygen plasma treatment, applying the polymer 70 to the substrate, imprinting a mold coated with microparticles on the substrate 50 applied with the polymer 70, and then performing UV hardening under a nitrogen atmosphere. Then, the organic EL device is manufactured by sequentially forming the first electrode 61, the organic light-emitting layer 62 and the second electrode 63 using methods known in the related art.

As such, in Patent Document 3, the corrugated part is formed by so called nano-imprinting. The nano-imprinting method, however, has a complicated process and increased process costs, such that it is difficult to achieve the mass production. Further, since the polymer is vulnerable to moisture, separate countermeasure for solving the problem of moisture permeation into the device is also required.

As another method for improving the light extraction efficiency other than the above-described methods, there is a technique in which a highly refractive material is inserted between a transparent electrode and a transparent substrate to minimize total reflection, thereby improving the light extraction efficiency. However, the process costs of the technique are also increased, and a deviation in light extraction efficiency occurs depending on the implemented color.

In addition, there is a technique for improving the light extraction efficiency by scattering internal photons by inserting a porous material between the transparent electrode and the substrate, however, the technique has a difficulty in applications to a structure having a large size, and a problem of reducing productivity.

Further, researches into a method of attaching a micro lens array (MLA) film to a surface of the substrate of the organic EL device, a method of changing surface roughness of the substrate using sand blasting, and the like, are also conducted.

However, in the method of attaching the MLA film, loss of photons emitted to the outside occurs due to a difference in optical properties (refractive index and absorbance) between the adhesive film and the MLA film, expensive equipment is required for attaching the film, thus the process costs are increased, and there is a high possibility that bubbles are introduced during the process of attaching the film. In the method using the sand blasting, there are also problems in that it is difficult to obtain uniform surface roughness, and the like.

As another method, there is a method of decreasing light totally reflected into the device using a high-refractive transparent substrate to improve the light extraction efficiency. However, the technique is still in the development stage, and there is a limit to apply the technique to a mass production process.

### [Disclosure]

### [Technical Problem]

An object of the present invention provides a method for manufacturing a substrate, a method for manufacturing an organic electroluminescence device using the substrate, and a substrate and an organic electroluminescence device manufactured by the methods, which are capable of reducing manufacturing costs of the device while improving light extraction efficiency of an organic EL device with a relatively simple process, by improving problems of the related art.

### [Technical Solution]

In order to accomplish the above object, according to the present invention, there is provided a method for manufacturing a substrate, including: forming a polymer layer on a substrate; and applying ion bombardment stress to the substrate on which the polymer layer is formed to form corrugated parts on the polymer layer.

In addition, according to the present invention, there is provided a method for manufacturing a substrate, including: forming a polymer layer on a substrate; forming a metal layer on the polymer layer; applying ion bombardment stress to the substrate on which the polymer layer and the metal layer are formed to form corrugated parts; and removing the metal layer.

Further, according to the present invention, there is provided a substrate manufactured by any one of the above methods.

Further, according to the present invention, there is provided a method for manufacturing an organic electroluminescence device, including: preparing the substrate manufactured by any one of the above methods; forming a first electrode on the corrugated parts; forming an organic light-emitting layer on the first electrode; and forming a second electrode on the organic light-emitting layer.

Further, according to the present invention, there is provided a method for manufacturing an organic electroluminescence device, including: preparing the substrate manufactured by any one of the above methods; forming a first electrode on a surface of the substrate opposite to a surface on which the corrugated parts are formed; forming an organic light-emitting layer on the first electrode; and forming a second electrode on the organic light-emitting layer.

Further, according to the present invention, there is provided an organic electroluminescence device, including: the substrate manufactured by any one of the above methods; a first electrode formed on the corrugated parts; an organic light-emitting layer formed on the first electrode; and a second electrode formed on the organic light-emitting layer.

Further, according to the present invention, there is provided an organic electroluminescence device, including: the substrate manufactured by any one of the above methods; a first electrode formed on a surface of the substrate opposite to a surface on which the corrugated parts are formed; an organic light-emitting layer formed on the first electrode; and a second electrode formed on the organic light-emitting layer.

Further, according to the present invention, there is provided an organic electroluminescence device, including: a substrate; a corrugated layer formed on the substrate; a first electrode formed on the corrugated layer; an organic light-emitting layer formed on the first electrode; and a second electrode formed on the organic light-emitting layer, wherein the corrugated layer is formed by applying ion bombardment stress to a polymer layer formed on the substrate.

Further, according to the present invention, there is provided an organic electroluminescence device, including: a substrate having a corrugated layer formed on one surface thereof; a first electrode formed on a surface of the substrate opposite to the surface on which the corrugated layer is formed; an organic light-emitting layer formed on the first electrode; and a second electrode formed on the organic light-emitting layer, wherein the corrugated layer is formed by applying ion bombardment stress to a polymer layer formed on the substrate.

Further, according to the present invention, there is provided an organic electroluminescence device, including: a substrate; a corrugated layer formed on the substrate; a first electrode formed on the corrugated layer; an organic light-emitting layer formed on the first electrode; and a second electrode formed on the organic light-emitting layer, wherein the corrugated layer is formed by applying ion bombardment stress to a polymer layer and a metal layer that are sequentially formed on the substrate, and after the ion bombardment stress is applied, the metal layer is removed.

Furthermore, according to the present invention, there is provided an organic electroluminescence device, including: a substrate having a corrugated layer formed on one surface thereof; a first electrode formed on a surface of the substrate opposite to the surface on which the corrugated layer is formed; an organic light-emitting layer formed on the first electrode; and a second electrode formed on the organic light-emitting layer, wherein the corrugated layer is formed by applying ion bombardment stress to a polymer layer and a metal layer that are sequentially formed on the substrate, and after the ion bombardment stress is applied, the metal layer is removed.

### [Advantageous Effects]

According to the organic EL device of the present invention, the corrugated layer having a plurality of corrugated parts is formed by a method of applying ion bombardment stress to the polymer layer laminated on the substrate, and the first electrode, the organic light-emitting layer, the second electrode, and the like are formed on the corrugated layer or on the surface of the substrate opposite to the surface on which the corrugated layer is formed, therefore it is possible to reduce an amount of light that is absorbed and disappeared in the organic EL device by the corrugated layer to improve extraction efficiency of the light emitted to an outside, thereby reducing power consumption for the same luminance.

Further, the process of forming the corrugated layer according to the present invention is simpler than the related art, and separate equipment is not required for forming the corrugated layer and the corrugated layer may be formed by using the existing equipment for manufacturing an organic EL device. Therefore, the present invention also has an effect that mass production is possible even with low costs.

### [Description of Drawings]

FIG. 1 is a cross-sectional view illustrating a schematic configuration of an organic EL device of the related art.
FIGS. 2A to 2D are views illustrating a process of manufacturing an organic EL device according to preferred Embodiment 1 of the present invention.
FIG. 3A is a cross-sectional view of the organic EL device manufactured according to Embodiment 1, and FIG. 3B is an electron microscope photograph of a corrugated part.
FIG. 4 is views illustrating a process of manufacturing an organic EL device according to preferred Embodiment 2 of the present invention.
FIG. 5 is views illustrating a process of manufacturing an organic EL device according to Modified Example 1.
FIG. 6 is views illustrating a process of manufacturing an organic EL device according to Modified Example 2.
FIG. 7 is graphs illustrating distribution charts of lights of the organic EL device manufactured by the method of the related art and the organic EL device manufactured by the method of Embodiment 1.
FIG. 8 is a graph illustrating voltage-current characteristics of the organic EL device manufactured by the method of the related art and the organic EL device manufactured by the method of Embodiment 1.
FIG. 9 is a graph illustrating voltage-current density characteristics of the organic EL device manufactured by the method of the related art and the organic EL device manufactured by the method of Embodiment 1.
FIG. 10 is a graph illustrating voltage-power efficiencies of the organic EL device manufactured by the method of the related art and the organic EL device manufactured by the method of Embodiment 1.
FIG. 11 is a graph illustrating voltage-luminance characteristics of the organic EL device manufactured by the method of the related art and the organic EL device manufactured by the method of Embodiment 1.
FIG. 12 is a cross-sectional view illustrating an organic EL device according to preferred Embodiment 3 of the present invention.
FIG. 13 is a graph illustrating the distribution charts of lights of the organic EL device manufactured by the method of the related art and the organic EL device manufactured by the method of the present invention.
FIG. 14 is a graph illustrating voltage-current density characteristics of the organic EL device manufactured by the method of the related art and the organic EL device manufactured by Embodiment 3.
FIG. 15 is a graph illustrating voltage-power efficiencies of the organic EL device manufactured by the method of the related art and the organic EL device manufactured by Embodiment 3.
FIG. 16 is a graph illustrating light emitting spectrum distribution for each wavelength range of the organic EL device manufactured by the method of the related art and the organic EL device manufactured by Embodiment 3.

### [Best Mode]

Hereinafter, preferred embodiments of the present invention will be described in detail with reference to the accompanying drawings.

### <Embodiment 1>

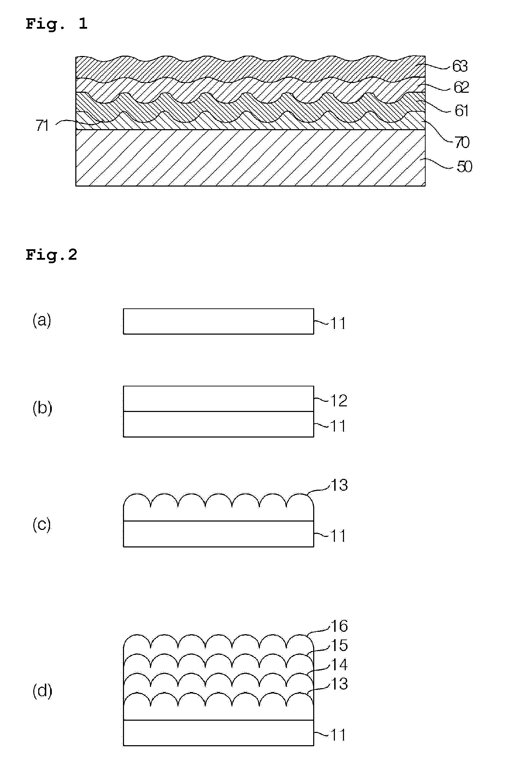

First, preferred Embodiment 1 of the present invention will be described with reference to FIG. 2. FIGS. 2A to 2D are views illustrating a process of manufacturing an organic EL device according to preferred Embodiment 1 of the present invention.

As illustrated in FIG. 2, first, a substrate 11 is prepared (see FIG. 2A). The substrate 11 is a substrate used in a conventional organic EL device 10, and for example, may be a transparent glass substrate, or a transparent plastic substrate.

Next, the substrate 11 is washed. The substrate 11 may be washed by a method known in the related art such as, for example, using a washing agent and an ultrasonic cleaner, and the washed substrate 11 is dried through a drying process.

Then, a polymer is applied to the washed and dried substrate to form a polymer layer 12 (see FIG. 2B).

As the polymer for forming the polymer layer 12, materials satisfying the following conditions are appropriately used.
1. Process should be stable with respect to an etchant, a developer, a stripper, and the like, and the polymer should not be chemically damaged from these substances.
2. The polymer should not be thermally damaged even in a heat treatment process at 300°C or higher.
3. Process should be out-gassing free.
4. A process of coating at a thickness of 1 µm or less should be possible.
5. Process of forming the polymer layer 12 should have reproducibility for stress.
6. A photolithography process should be possible.
7. The polymer layer should have appropriate optical coefficients such as a refractive index of 1.5 or more, a low light absorption rate (low extinction coefficient), transmittance of 90% or more, and the like.

In the present embodiment, as a material of the polymer layer 12, touch screen over coating material SOI-4000 of Samyang Co. was used.

As a method of coating a polymer, a spin coating method was used in the present embodiment, and a coating speed was in a range of 500 to 2000 RPM, and a coating thickness of the polymer layer 12 was 0.3 to 3.0 µm. However, the coating method is not limited to the spin coating method, but other methods may be used so long as it is a method capable of forming the polymer layer 12 by applying a polymer to the substrate 11 at a predetermined thickness.

Next, soft baking was performed at a temperature of 100°C for about 90 seconds, then ion bombardment stress was applied to a surface of the polymer layer 12 to form a plurality of corrugated parts (concavo-convexes) on the surface of the polymer layer 12, thereby forming the corrugated layer 13 (see FIG. 2C).

The corrugated layer 13 is formed by introducing the substrate 11 on which the polymer layer 12 is formed into a plasma treatment apparatus to perform plasma treatment. In the present embodiment, argon was used as a gas for treatment, a gas flow rate was 70 to 200 SCCM, a pressure was 8 Pa, power was in a range of 50 to 200 W, and treatment time was in a range of 1 to 20 minutes.

Next, a hardening process was performed for hardening the same for about 2 to 6 hours while gradually decreasing the temperature of about 230°C at the start to room temperature to obtain the substrate on which the corrugated layer 13 is formed.

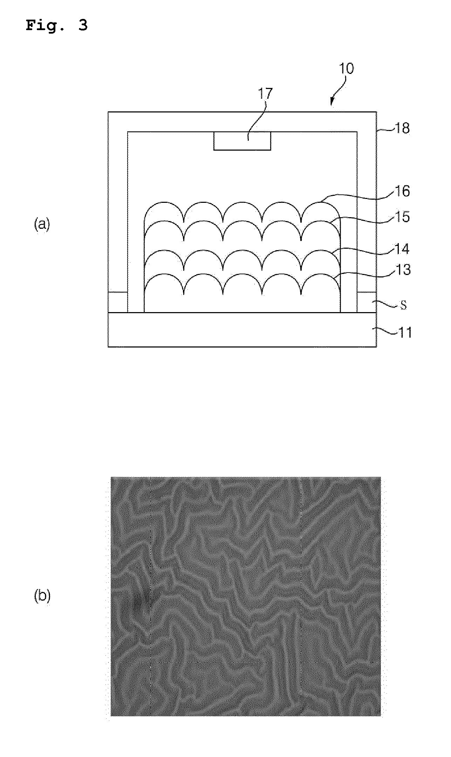

FIG. 3B is an electron microscope photograph (taken by confocal laser scanning microscope LEXT OLS3000 of Olympus Co.) of the corrugated layer 13 formed on the substrate 11, and it can be confirmed that the plurality of corrugated parts are relatively periodically formed on the substrate 11.

A thickness of the polymer layer 12, a period and a height of the corrugated parts of the formed corrugated layer 13 depending on the coating speed are as shown in Table 1 below.

**[Table 1]**

| | Coating speed (RPM) | Coating thickness (µm) | Average period of corrugated parts (µm) | Average height of corrugated parts (µm) |
|---|---|---|---|---|
| Sample 1 | 500 | 3.0 | 7.0 | 0.60 |
| Sample 2 | 1000 | 1.5 | 4.9 | 0.86 |
| Sample 3 | 1500 | 0.9 | 3.5 | 0.18 |
| Sample 4 | 2000 | 0.3 | 2.6 | 0.11 |

It can be seen from the above Table 1 that the coating thickness of the polymer layer 12, and an average period and an average height of the corrugated parts of the corrugated layer 13 are directly associated with the coating speed by the spin coating, and it can be seen from the above results that the coating thickness of the polymer layer 12 may be appropriately set depending on characteristics of the device such as a use, a size, a material, etc. of the organic EL device 10, and accordingly the period and the height of the corrugated layer 13 may be appropriately set as necessary.

In the present embodiment, a size of the corrugated part is preferably 300 nm to 200 µm, and if the size of the corrugated part is less than 300 nm, or exceeds 200 µm, effects of the present invention were insignificant.

Further, the light extraction efficiency is also affected by a shape of the corrugated part. That is, the light extraction efficiency may be more improved when the corrugated part has a shape such as an elliptical shape or an irregular shape, than the case that the corrugated part has a complete spherical shape.

Further, in the present embodiment, as a method of applying ion bombardment stress to the surface of the polymer layer 12, a method of using argon plasma treatment was used, but it is not limited thereto. The corrugated layer 13 may also be formed by applying the ion bombardment stress to the surface of the polymer layer 12 by other suitable methods.

Then, a first electrode 14, an organic light-emitting layer 15, and a second electrode 16 are sequentially formed on the corrugated layer 13 as illustrated in FIG. 2D.

When the first electrode is a cathode, the second electrode is an anode, and when the first electrode is an anode, the second electrode is a cathode. The polarity of the electrodes is appropriately determined depending on whether the organic EL device of the present invention is a front emission type or a rear emission type.

As a method, a material, a condition, and the like for forming the first electrode, the organic light-emitting layer, the second electrode, and the like, various methods known in the related art may be selectively used, and it is not the subject matter of the present invention, therefore, will not be described in detail.

Further, although not illustrated in FIG. 2D, if necessary, a getter 17 or the like may be further formed, and then a cover glass 18 may be sealed thereon, thereby completing the organic EL device 10 (see FIG. 3A).

FIG. 3A is a cross-sectional view illustrating the organic EL device 10 in which the first electrode 14, the organic light-emitting layer 15, the second electrode 16, and the like are sequentially formed on the corrugated layer 13 that is formed on the substrate 11 by the method described in the present embodiment.

A sealing material S is filled between the substrate 11 and the cover glass 18 to seal the same.

In the organic EL device 10 according to the present embodiment as described above, the corrugated layer 13 having a plurality of corrugated parts is formed by a method of applying the ion bombardment stress to the polymer layer 12 laminated on the substrate 11, and the first electrode 14, the organic light-emitting layer 15, the second electrode 16, and the like are sequentially formed on the corrugated layer 13, therefore it is possible to improve the extraction efficiency of the light emitted to an outside of the organic EL device 10 by the corrugated layer 13, and thereby reducing power consumption for the same luminance.

Further, the process of forming the corrugated layer 13 according to the present invention is simpler than the related art, and separate equipment such as imprinting equipment is not required for forming the corrugated layer 13 and the corrugated layer may be formed by using the existing equipment for manufacturing an organic EL device. Therefore, the present invention also has an effect that mass production is possible even with low costs.

### <Experiment for Effect>

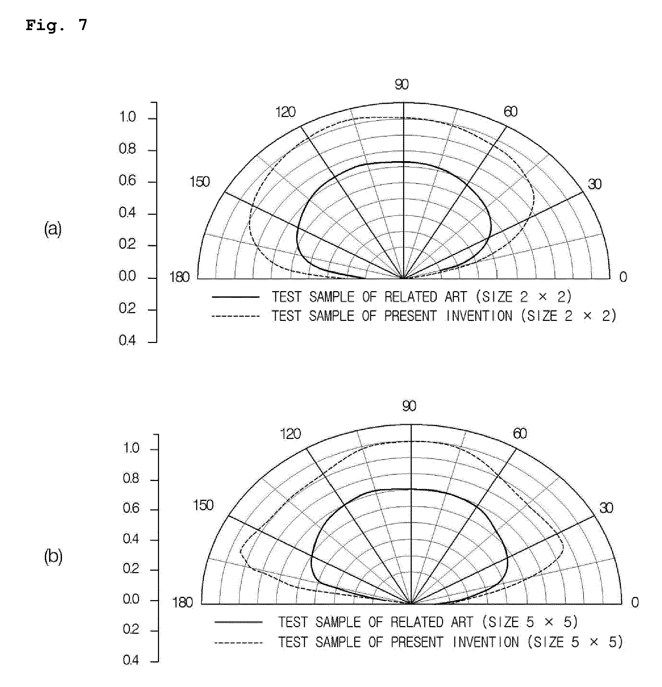

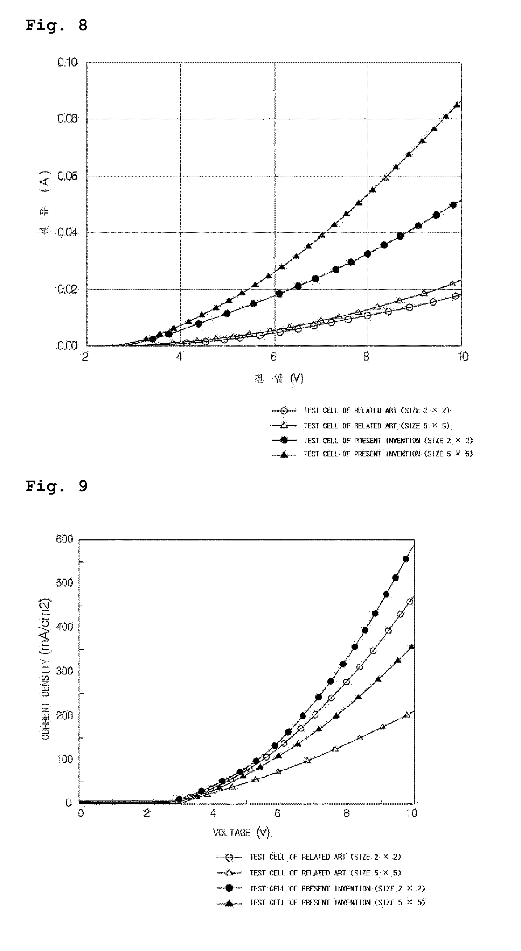

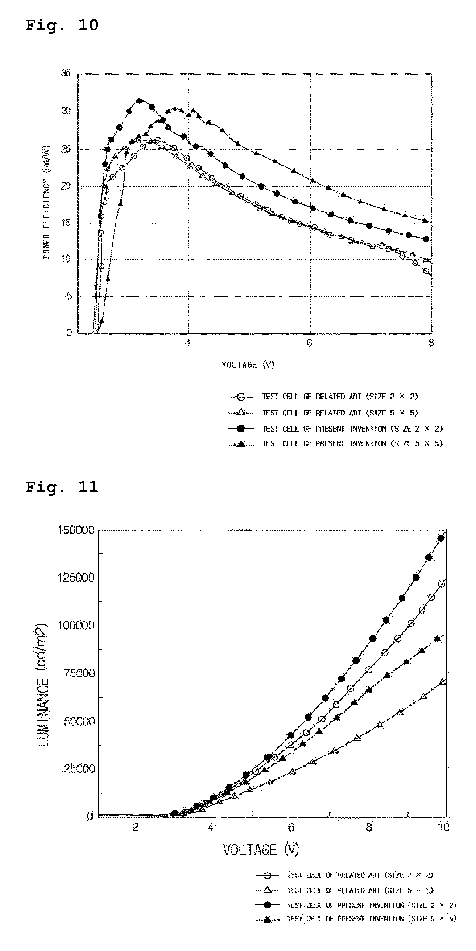

In order to confirm electrical and optical properties of Embodiment 1, a sample having a size of 2 × 2 inches and a sample having a size of 5 × 5 inches for the organic EL devices of the related art which do not include the corrugated layer between the substrate and the first electrode, and a sample having a size of 2 × 2 inches and a sample having a size of 5 × 5 inches for the organic EL devices of Embodiment 1 which include the corrugated layer between the substrate and the first electrode, were manufactured, and various experiments were conducted thereon. Hereinafter, the results thereof will be described.
(1) First, luminous intensity distribution analysis for showing distribution charts of light was performed on the test samples of the related art and the test samples of Embodiment 1, and the results thereof are illustrated in FIG. 7. FIG. 7A shows the result of the sample having a size of 2 × 2 inches, and FIG. 7B shows the result of the sample having a size of 5 × 5 inches.
The measurement was performed by using a goniophotometer (Pimacs Co., Ltd.), and as illustrated in FIG. 7, it can be seen that luminous intensity distribution was remarkably improved in both of the sample having a size of 2 × 2 inches and the sample having a size of 5 × 5 inches that include the corrugated layer of Embodiment 1, as compared to the samples of the related art.
(2) Next, measurement of voltage-current characteristics and measurement of voltage-current density characteristics were performed on the test samples of the related art and the test samples of Embodiment 1, and the results thereof are illustrated in FIGS. 8 and 9, respectively.
As illustrated in FIGS. 8 and 9, it can be seen that both of current values and current densities at the same voltage were improved in both of the sample having a size of 2 × 2 inches and the sample having a size of 5 × 5 inches that include the corrugated layer of Embodiment 1, as compared to the samples of the related art.
(3) Further, a relationship between the voltage and the power efficiency and a relationship between the voltage and the luminance in the test samples of the related art and the test samples of Embodiment 1 were also measured, and the results thereof are illustrated in FIGS. 10 and 11, respectively.
The luminance was measured by using a BM-7 luminance colorimeter of Topcon Co., and as illustrated in FIGS. 10 and 11, it can be seen that the power efficiency and the luminance at the same voltage were improved in both of the sample having a size of 2 × 2 inches and the sample having a size of 5 × 5 inches that include the corrugated layer of Embodiment 1, as compared to the samples without the corrugated layer of the related art.
(4) Further, an entire luminous flux was measured using an integrating sphere photometer, from which lighting efficiency and lighting efficiency improvement rate of the test samples of the related art and the test samples of Embodiment 1 were measured, respectively. The results thereof are as shown in Table 2.

**[Table 2]**

| | Test cell of related art | | | Test cell of present invention | | | Improve ment rate (%) |
|---|---|---|---|---|---|---|---|
| | Power (W) | Luminance (lm) | Lighting effici ency (lm/W) | Power (W) | Luminance (lm) | Lighting effici ency (lm/W) | |
| 2 × 2 inches | 0.006 | 0.12 | 20.00 | 0.006 | 0.175 | 29.66 | 48.3 |
| 5 × 5 inches | 0.041 | 0.63 | 15.37 | 0.037 | 0.850 | 22.84 | 48.7 |

As shown in Table 2, the lighting efficiency of both of the sample having a size of 2 × 2 inches and the sample having a size of 5 × 5 inches that include the corrugated layer of Embodiment 1 was much higher than the samples without the corrugated layer of the related art. The lighting efficiency improvement rate of both of the sample having a size of 2 × 2 inches and the sample having a size of 5 × 5 inches was also improved by 48% or more.

It can be confirmed from the above experiment results that the extraction efficiency of the light emitted to the outside of the organic EL device may be improved by the corrugated layer according to Embodiment 1, and thus the power consumption for the same luminance may be reduced.

### <Embodiment 2>

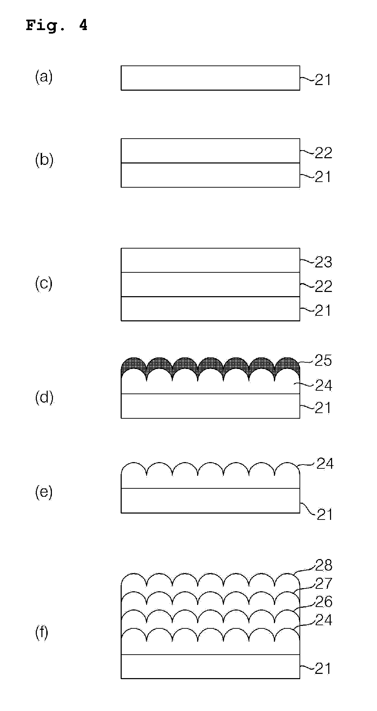

Next, preferred Embodiment 2 of the present invention will be described with reference to FIG. 4. FIGS. 4A to 4F are views illustrating a process of manufacturing an organic EL device according to preferred Embodiment 2 of the present invention.

Except for the process of forming the corrugated layer, processes in Embodiment 2 are the same as described in Embodiment 1, therefore, hereinafter, differences from Embodiment 1 will be mainly described.

First, a polymer is applied to a transparent substrate 21 such as a glass substrate or a plastic substrate to form a polymer layer 22 (see FIGS. 4A and 4B). A material of the substrate 21 and a method for forming the polymer layer 22 are the same as the material of the substrate 11 and the method for forming the polymer layer 12 in Embodiment 1, respectively.

Next, a metal layer 23 is deposited on the polymer layer 22 (see FIG. 4C). The deposition of the metal layer 23 may be performed by a conventional method of depositing a metal layer such as ion beam deposition, and in the present embodiment, the metal layer 23 was deposited at a rate of 0.1 nm per second and a total thickness of 10 nm.

As the material for forming the metal layer 23, for example, aluminum (Al) may be used. Since a difference in thermal expansion coefficient between aluminum and the polymer layer 22 is large, a corrugated sacrificial layer 25 may be easily formed. However, the material for forming the metal layer 23 is not limited to aluminum, but other metals may also be used.

Next, a corrugated layer 24 and the corrugated sacrificial layer 25 are formed on the polymer layer 22 and the metal layer 23, respectively, by applying ion bombardment stress to the substrate on which the polymer layer 22 and the metal layer 23 are formed (see FIG. 4D). A method and a condition for applying the ion bombardment stress to the substrate on which the polymer layer 22 and the metal layer 23 are formed are the same as those of the corrugated layer 13 in Embodiment 1.

Next, after applying the ion bombardment stress, heating stress is applied to the substrate on which the polymer layer 22 and the metal layer 23 are formed. The heating stress may be directly applied to the substrate on which the polymer layer 22 and the metal layer 23 are formed, or may be applied by introducing the substrate applied with the ion bombardment stress into a heating furnace and gradually cooling the substrate from the temperature of about 230°C at the start to room temperature for about 2 hours.

The ion bombardment stress and the heating stress may be simultaneously applied in the same process, or the heating stress may be further applied after the ion bombardment stress is applied. In the present embodiment, the heating stress is further applied to the substrate on which the polymer layer 22 and the metal layer 23 are laminated, such that the corrugated layer 24 and the corrugated sacrificial layer 25 are more reliably formed by the difference in thermal expansion coefficient between the polymer and the metal.

Next, the corrugated sacrificial layer 25 made of metal is removed by etching, so that only the corrugated layer 24 made of the polymer remains (see FIG. 4E). In the present embodiment, as an etchant, an aluminum etchant was used, and the corrugated sacrificial layer 25 made of metal was completely removed by wet-etching at a temperature of 40°C for 3 minutes.

Herein, as the etchant, when the material of the metal sacrificial layer 25 is aluminum, the aluminum etchant by which the corrugated sacrificial layer 25 may be most easily removed, was used. However, when other metals except for aluminum were used as the material of the metal sacrificial layer 25, an appropriate etchant that may easily remove the corresponding metal sacrificial layer may be used.

Next, the hardening process was performed to obtain a substrate on which a plurality of corrugated layers 24 are formed over the entire surface thereof.

The hardening process in Embodiment 2 is the same as described in Embodiment 1.

Next, as illustrated in FIG. 4F, layers including a first electrode 26, an organic light-emitting layer 27, and a second electrode 28 are sequentially formed on the corrugated layer 24, and if necessary, a getter or the like is further formed and then the organic EL device is sealed by a cover glass, thereby completing the same.

In the present embodiment, the corrugated layer may be more reliably and easily formed than Embodiment 1 by further forming the metal layer 23 on the polymer layer 22 and further applying the heating stress in addition to the ion bombardment stress to the polymer layer 22 and the metal layer 23.

In the present embodiment, electrical and optical properties were not confirmed, however, since the corrugated layer may be more reliably formed than Embodiment 1, it may be guessed that the electrical and optical properties of the organic electroluminescence device manufactured by the method of Embodiment 2 will be more improved.

### <Modified Example 1>

In Embodiment 1, the corrugated layer 13 was formed by applying the ion bombardment stress to the entire polymer layer 12 formed on the substrate 11, however, a patterning process of patterning the polymer layer 12 formed on the substrate 11 at a predetermined size may be further performed.

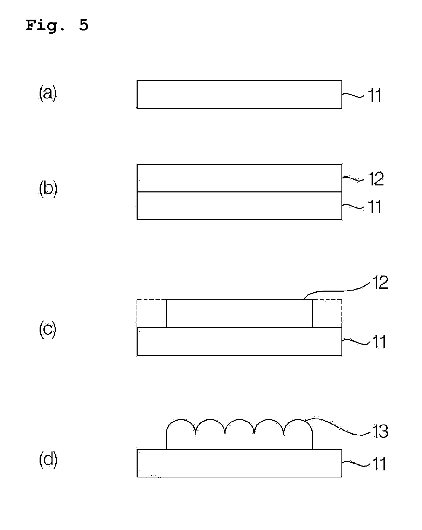

Modified Example in which the patterning process is further performed will be briefly described with reference to FIG. 5.

FIGS. 5A and 5B are the same as FIGS. 2A and 2B of Embodiment 1, and in FIG. 5C, the polymer layer 12 is patterned at a predetermined size.

The reason to perform the patterning is that although the organic EL device is finally sealed by the cover glass as illustrated in FIG. 3, since the polymer is very vulnerable to moisture, when the corrugated layer 13 made of the polymer is exposed to the outside of the cover glass, it is very likely that the moisture will permeate into the organic EL device, further, since the first electrode, the organic light-emitting layer, the second electrode, and the like are formed only in a region inside the cover glass, it is necessary for a size of the corrugated layer 13 to be matched with the sizes of the first electrode, the organic light-emitting layer, the second electrode, and the like.

In particular, as illustrated in FIG. 3A, in order to prevent the problem in which moisture permeates into the organic EL device, the sealing material S is filled between the substrate 11 and the cover glass 18 to seal the same. However, when the size of the corrugated layer 13 having a surface on which the corrugated parts are formed is larger than a size of an inner peripheral surface of the cover glass, the substrate and the cover glass are not closely adhered to each other due to the corrugated parts, and the substrate and the cover glass may not be directly sealed by the sealing material S. Therefore, the polymer layer 12 is patterned at a predetermined size to solve the above described problems.

Portions indicated by dotted lines in FIG. 5C are the portions removed by the patterning process, and the patterning is performed through a conventional photo process and a development process, therefore the patterning method will not be described in detail.

### <Modified Example 2>

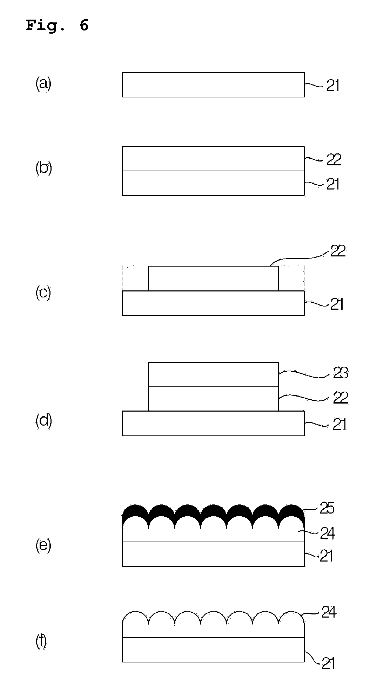

In Embodiment 2, the corrugated layer 24 was formed by forming the metal layer 23 over the entire polymer layer 22 formed on the substrate 21 and applying the ion bombardment stress and the heating stress thereto. However, the patterning process of patterning the polymer layer 22 formed on the substrate 21 may be further performed as in Modified Example 1 (FIG. 6C), and then the metal layer 23 may be formed so that a size thereof is matched with the size of the polymer layer 22 that is patterned to have a predetermined shape (FIG. 6D). Subsequent processes are the same as those of FIGS. 4D and 4E described in Embodiment 2.

Further, the reason to pattern the polymer layer 22 at a predetermined size is the same as described in Modified Example 1.

### <Embodiment 3>

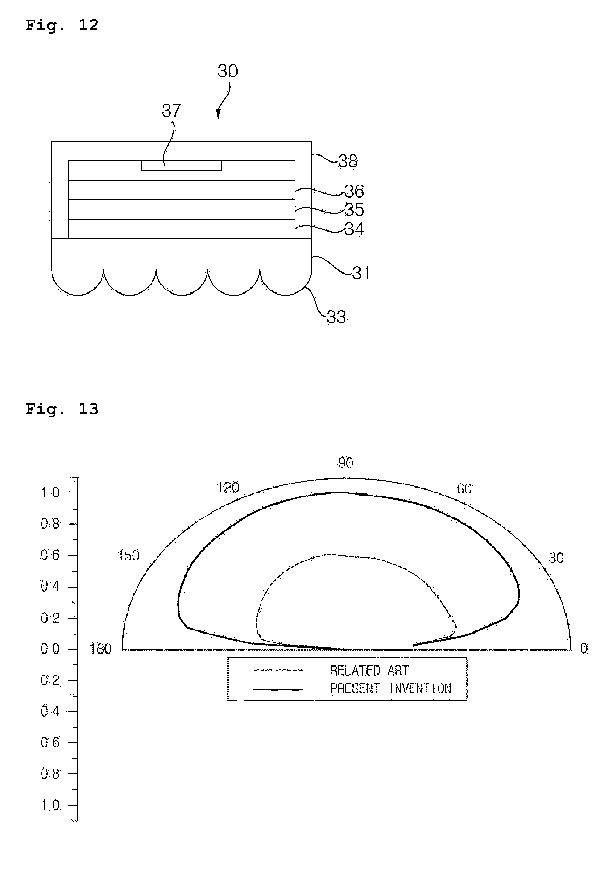

Next, preferred Embodiment 3 of the present invention will be described with reference to FIG. 12. FIG. 12 is a cross-sectional view illustrating an organic EL device according to preferred Embodiment 3 of the present invention.

Embodiment 3 is different from Embodiments 1 and 2, and Modified Examples 1 and 2 in that in the organic EL devices of Embodiments 1 and 2, and Modified Examples 1 and 2, the first electrode, the organic light-emitting layer, the second electrode, and the like are formed on the corrugated layer, but in Embodiment 3, the first electrode, the organic light-emitting layer, the second electrode, and the like are formed on a surface of the substrate opposite to a surface on which the corrugated layer is formed.

As illustrated in FIG. 12, in an organic EL device 30 of Embodiment 3, a first electrode 34, an organic light-emitting layer 35, and a second electrode 36 are sequentially formed on a surface of the substrate 31 opposite to the surface on which a corrugated layer 33 is formed, and if necessary, a getter 37 or the like is further included and finally the organic EL device is sealed by a cover glass 38.

The substrate 31 used in Embodiment 3 may be the substrate manufactured by any one of the above-described methods in Embodiments 1 and 2, and Modified Examples 1 and 2.

When the first electrode is a cathode, the second electrode is an anode, and when the first electrode is an anode, the second electrode is a cathode. The polarity of the electrodes is appropriately determined depending on whether the organic EL device of the present invention is a front emission type or a rear emission type. However, the corrugated layer 33 side of the substrate 31 serves as a light emitting surface through which the light is emitted. As a method, a material, a condition, or the like for forming the first electrode, the organic light-emitting layer, the second electrode, and the like, various methods known in the related art may be selectively used.

### <Experiment for Effect>

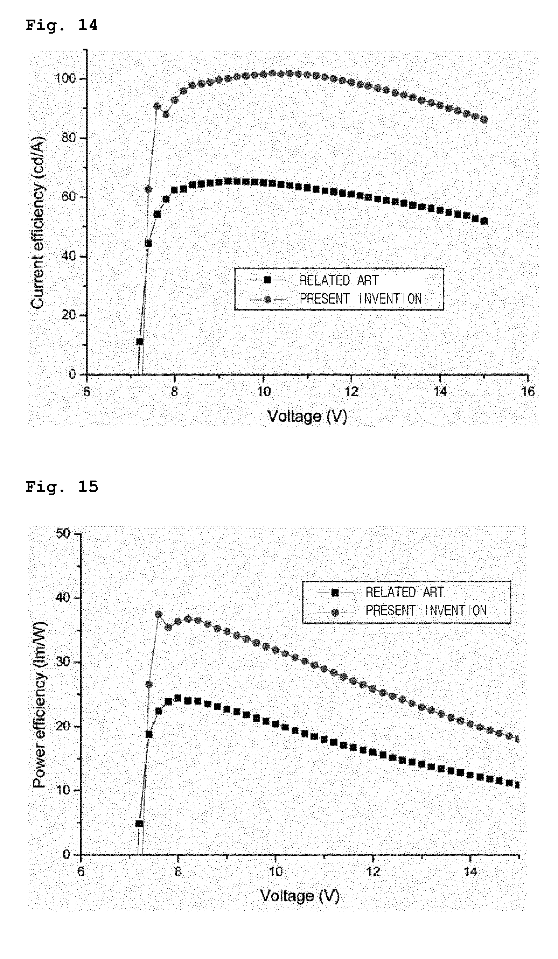

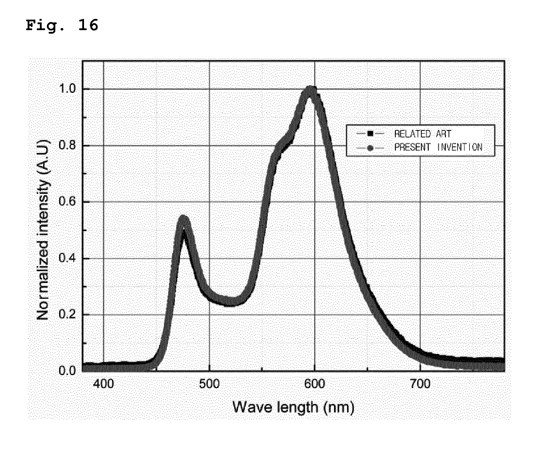

In order to confirm electrical and optical properties for the organic EL device of Embodiment 3, a sample of the organic EL device of the related art which does not include the corrugated layer on the light emitting surface side of the substrate, and a sample of the organic EL device of Embodiment 3 which includes the corrugated layer on the light emitting surface side of the substrate, were manufactured, and various experiments were conducted thereon. Hereinafter, the results thereof will be described.
(1) First, luminous intensity distribution analysis for showing the distribution charts of light was performed on the test sample of the related art and the test sample of Embodiment 3, and the results thereof are illustrated in FIG. 13.
   The measurement was performed by using a goniophotometer (Pimacs Co., Ltd), and as illustrated in FIG. 13, it can be seen that luminous intensity distribution was remarkably improved in the sample having the corrugated layer of Embodiment 3, as compared to the sample of the related art.
(2) Next, measurement of voltage-current efficiency characteristic was performed on the test sample of the related art and the test sample of Embodiment 3, and the results thereof are illustrated in FIG. 14.
   As illustrated in FIG. 14, it can be seen that the current efficiency at the same voltage was remarkably improved in the sample having the corrugated layer of Embodiment 3, as compared to the sample of the related art.
(3) Further, measurement of a relationship between the voltage and the power efficiency was also performed on the test sample of the related art and the test sample of Embodiment 3, and the results thereof are illustrated in FIG. 15.
   As illustrated in the graph of FIG. 15, it can be seen that the power efficiency at the same voltage was remarkably improved in the sample having the corrugated layer of Embodiment 3, as compared to the sample without the corrugated layer of the related art.
(4) Further, measurement of light emitting spectrum distribution for each wavelength range was performed on the test sample of the related art and the test sample of Embodiment 3, and the results thereof are illustrated in FIG. 16.
   As illustrated in the graph of FIG. 16, no particular change in the light emitting spectrum distribution for each wavelength region was observed in the test sample of the related art and the test sample of Embodiment 3. Therefore, it can be seen that there is no substantial change in color of the light emitted from the organic EL device even with the structure of Embodiment 3.
(5) In addition, in the present embodiment, as a substrate for the organic EL device, the substrate manufactured by the method of Embodiments 1 and 2, and Modified Examples 1 and 2 is used, therefore, it is apparent that effects that are the same as those of Embodiments 1 and 2, and Modified Examples 1 and 2 may be obtained.

While preferred embodiments and modified examples of the present invention have been described. However, the embodiments and modified examples merely suggest a preferred form of the present invention, and thus the present invention is not limited to the embodiments and modified examples. The present invention may be variously changed and modified without departing from the scope and technical idea of the present invention.

Further, each embodiment and each modified example may also be combined with each other.

## Claims

1. A method for manufacturing a substrate, comprising:
forming a polymer layer on a substrate; and
applying ion bombardment stress to the substrate on which the polymer layer is formed to form corrugated parts on the polymer layer.

2. A method for manufacturing a substrate, comprising:
forming a polymer layer on a substrate;
forming a metal layer on the polymer layer;
applying ion bombardment stress to the substrate on which the polymer layer and the metal layer are formed to form corrugated parts; and
removing the metal layer.

3. The method according to claim 1 or 2, wherein the ion bombardment stress is applied by argon plasma treatment.

4. The method according to claim 2, further applying heating stress to the substrate on which the metal layer is formed.

5. The method according to claim 4, wherein the ion bombardment stress and the heating stress are simultaneously applied.

6. The method according to claim 4, wherein the ion bombardment stress is first applied and then the heating stress is applied.

7. The method according to claim 1 or 2, further comprising patterning the polymer layer in a predetermined shape.

8. A substrate manufactured by the method according to any one of claims 1 to 7.

9. A method for manufacturing an organic electroluminescence device, comprising:
preparing the substrate according to claim 8; forming a first electrode on the corrugated parts;
forming an organic light-emitting layer on the first electrode; and
forming a second electrode on the organic light-emitting layer.

10. A method for manufacturing an organic electroluminescence device, comprising:
preparing the substrate according to claim 8;
forming a first electrode on a surface of the substrate opposite to a surface on which the corrugated parts are formed;
forming an organic light-emitting layer on the first electrode; and
forming a second electrode on the organic light-emitting layer.

11. An organic electroluminescence device, comprising:
the substrate according to claim 8;
a first electrode formed on the corrugated parts;
an organic light-emitting layer formed on the first electrode; and
a second electrode formed on the organic light-emitting layer.

12. An organic electroluminescence device, comprising:
the substrate according to claim 8;
a first electrode formed on a surface of the substrate opposite to a surface on which the corrugated parts are formed;
an organic light-emitting layer formed on the first electrode; and
a second electrode formed on the organic light-emitting layer.

13. An organic electroluminescence device, comprising:
a substrate;
a corrugated layer formed on the substrate;
a first electrode formed on the corrugated layer;
an organic light-emitting layer formed on the first electrode; and
a second electrode formed on the organic light-emitting layer,
wherein the corrugated layer is formed by applying ion bombardment stress to a polymer layer formed on the substrate.

14. An organic electroluminescence device, comprising:
a substrate having a corrugated layer formed on one surface thereof;
a first electrode formed on a surface of the substrate opposite to the surface on which the corrugated layer is formed;
an organic light-emitting layer formed on the first electrode; and
a second electrode formed on the organic light-emitting layer,
wherein the corrugated layer is formed by applying ion bombardment stress to a polymer layer formed on the substrate.

15. An organic electroluminescence device, comprising:
a substrate;
a corrugated layer formed on the substrate;
a first electrode formed on the corrugated layer;
an organic light-emitting layer formed on the first electrode; and
a second electrode formed on the organic light-emitting layer,
wherein the corrugated layer is formed by applying ion bombardment stress to a polymer layer and a metal layer that are sequentially formed on the substrate, and
after the ion bombardment stress is applied, the metal layer is removed.

16. An organic electroluminescence device, comprising:
a substrate having a corrugated layer formed on one surface thereof;
a first electrode formed on a surface of the substrate opposite to the surface on which the corrugated layer is formed;
an organic light-emitting layer formed on the first electrode; and
a second electrode formed on the organic light-emitting layer,
wherein the corrugated layer is formed by applying ion bombardment stress to a polymer layer and a metal layer that are sequentially formed on the substrate, and
after the ion bombardment stress is applied, the metal layer is removed.
